# EUROPEAN PATENT APPLICATION

(11) **EP 1 569 262 A2**
(43) Date of publication of application: **31.08.2005**
(21) Application number: 05004338.9
(22) Date of filing: 28.02.2005
(51) Int. Cl.: H01L 21/00

(54) **Methods and apparatus for enhanced operation of substrate carrier handlers**

(30) Priority: 28.02.2004 US 548584 P; 04.11.2004 US 981131
(71) Applicant: APPLIED MATERIALS, INC., California 95054 (US)
(72) Inventor: Teferra, Michael, Los Gatos CA 95032 (US); Puri, Amit, San Jose CA 95148 (US)
(74) Representative: Zimmermann, Gerd Heinrich

(57) **Abstract**

A carrier handler is provided that may be adapted to (1) accept transfer commands for carriers before the carriers arrive within the domain of the carrier handler (302); (2) accept termination commands that result in prior commands being cancelled or aborted independent of the state of the prior commands; (3) select queued commands for out-of-order execution to take advantage of earliest arriving transport system (316) carrier supports suitable for use with the selected commands and/or based upon the anticipated time needed to execute the commands; (4) remove empty carriers from an associated tool to improve port availability; (5) continue to operate even after transfers involving storage locations fail by removing the failed locations from a usable locations list; (6) verify the integrity of carrier and transfer destination status data with sensors prior to attempting a transfer; and (7) calibrate carrier handoffs with a transport system using a calibration carrier equipped with sensors.

## Description

The present invention relates generally to electronic device fabrication systems, and is more particularly concerned with transferring substrate carriers between transport systems and processing tools within a fabrication facility.

Manufacturing of electronic devices typically involves performing a sequence of procedures with respect to a substrate such as a silicon substrate, a glass plate, etc. (Such substrates may also be referred to as wafers, whether patterned or unpatterned.) These steps may include polishing, deposition, etching, photolithography, heat treatment, and so forth. Usually a number of different processing steps may be performed in a single processing system or "tool" which includes a plurality of processing chambers. However, it is generally the case that other processes are required to be performed at other processing locations within a fabrication facility, and it is accordingly necessary that substrates be transported within the fabrication facility from one processing location to another. Depending upon the type of electronic device to be manufactured, there may be a relatively large number of processing steps required to be performed at many different processing locations within the fabrication facility.

It is conventional to transport substrates from one processing location to another within substrate carriers such as sealed pods, cassettes, containers and so forth. It is also conventional to employ automated substrate carrier transport devices, such as automatic guided vehicles, overhead transport systems, substrate carrier handling robots, etc., to move substrate carriers from location to location within the fabrication facility or to transfer substrate carriers from or to a substrate carrier transport device.

For an individual substrate, the total fabrication process, from formation or receipt of the virgin substrate to cutting of semiconductor devices from the finished substrate, may require an elapsed time that is measured in weeks or months. In a typical fabrication facility, a large number of substrates may accordingly be present at any given time as "work in progress" (WIP). The substrates present in the fabrication facility as WIP may represent a very large investment of working capital, which tends to increase the per substrate manufacturing cost. It may therefore be desirable to reduce the amount of WIP for a given substrate throughput for the fabrication facility. To do so, the total elapsed time for processing each substrate should be reduced.

The present invention intends to overcome at least some of the above problems. The object is solved by the methods according to independent claims 1, 6, 7, 10, 15, 21, 24, 26, and 28.

Further advantages, features, aspects and details of the invention are evident from the dependent claims, the description and the drawings.

In a first aspect of the invention, a method is provided in which an anticipated arrival of a carrier at a carrier handler is determined and an expected carrier transfer command is issued to the carrier handler before the carrier arrives at the carrier handler.

In a second aspect of the invention, a method is provided in which a carrier handler adapted to remove a carrier from a transport system and to load the carrier on a port of a processing tool serviced by the carrier handler accepts a command at the carrier handler for loading the carrier on the processing tool. The command is accepted prior to arrival of the carrier at the carrier handler.

In a third aspect of the invention, a method is provided in which a carrier handler command is defined having an associated function of terminating a second command independent of a state in which the second command may be operating.

In a fourth aspect of the invention, a method is provided in which an earliest arriving carrier support is identified that is approaching a carrier handler and is available to satisfy one or more queued transfer commands in a command queue. A queued transfer command is selected to initiate next from among the queued transfer commands based upon an anticipated time until an arrival of the earliest arriving carrier support.

In a fifth aspect of the invention, a method is provided in which information related to execution times of carrier handler commands is stored and a queued transfer command to initiate next is selected from among a plurality of queued transfer commands based upon the stored information.

In a sixth aspect of the invention, a method is provided in which a first signal indicative of a status of contents of a carrier at a port associated with a tool is received. The status indicates whether (a)the carrier contains one or more substrates to be processed by the tool, or (b) the carrier is empty or contains only one or more substrates that have already been processed by the tool. A second signal indicative that the carrier is ready to be removed from the port is received and a transfer of the carrier based upon the first and second signals is performed.

In a seventh aspect of the invention, a method is provided in which a failed transfer of a carrier by a robot of a carrier handler, from or to an internal storage location, is detected, information indicating that the internal storage location is unusable is stored, and an alternative storage location is identified in place of the unusable internal storage location.

In an eighth aspect of the invention, a method is provided in which locations of each of a plurality of carriers within a domain of a carrier handler are tracked, a status of each of a plurality of destination locations for carriers within the domain of the carrier handler are tracked, and the location of a carrier and the status of a destination location within the domain is verified using at least one sensor before executing a transfer of the carrier to the destination location.

In a ninth aspect of the invention, a method is provided in which a carrier handler is installed adjacent a transport system, a calibration carrier is moved past the carrier handler, and the carrier handler is calibrated to the transport system based upon information determined from the calibration carrier moving past the carrier handler on the transport system.

The invention is also directed to apparatuses for carrying out the disclosed methods and including apparatus parts for performing each described method steps. These method steps may be performed by way of hardware components, a computer programmed by appropriate software, by any combination of the two or in any other manner.

Other features and aspects of the present invention will become more fully apparent from the following detailed description of exemplary embodiments, the appended claims and the accompanying drawings, wherein:
Figure 1 is a block diagram depicting an example of a control system for an electronic device manufacturing facility according to some embodiments of the present invention.
Figure 2 is a schematic diagram depicting an example of an electronic device manufacturing facility according to some embodiments of the present invention.
Figure 3 is a front elevational view depicting an example of a carrier handler according to some embodiments of the present invention.
Figure 4 is a flowchart depicting an example process for accepting a transfer command before a carrier arrives at a carrier handler according to some embodiments of the present invention.
Figure 5 is a flowchart depicting an example process for terminating a transfer command independent of the command's execution status according to some embodiments of the present invention.
Figure 6 is a flowchart depicting an example process for looking ahead into a command queue to find a command that can use the earliest arriving available carrier support according to some embodiments of the present invention.
Figure 7 is a flowchart depicting an example process for storing and using execution times to efficiently schedule commands according to some embodiments of the present invention.
Figure 8 is a flowchart depicting an example process for removal of empty substrate carriers from a processing tool according to some embodiments of the present invention.
Figure 9 is a flowchart depicting an example process for recovering from failed transfers according to some embodiments of the present invention.
Figure 10 is a flowchart depicting an example process for verifying that stored status data is accurate before executing transfers according to some embodiments of the present invention.
Figure 11 is a flowchart depicting an example process for calibrating a handoff between a carrier handler and a transport system according to some embodiments of the present invention.

The present application claims priority from U.S. Patent Application Serial No. 10/981,131, filed November 4, 2004, which claims priority from U.S. Provisional Patent Application Serial No. 60/518,583 filed November 6, 2003. The present application claims priority from U.S. Provisional Patent Application Serial No. 60/548,584, filed February 28, 2004. The content of each of the above-identified patent applications is hereby incorporated by reference herein in its entirety.

The present application is related to the following commonly-assigned, co-pending U.S. Patent Applications, each of which is hereby incorporated by reference herein in its entirety:
U.S. Patent Application filed February 25, 2005, and titled "METHODS AND APPARATUS FOR MATERIAL CONTROL SYSTEM INTERFACE";
U.S. Patent Application filed February 25, 2005, and titled "METHODS AND APPARATUS FOR TRANSFERRING A SUBSTRATE CARRIER WITHIN AN ELECTRONIC DEVICE MANUFACTURING FACILITY";
U.S. Patent Application filed February 25, 2005, and titled "METHODS AND APPARATUS FOR ELECTRONIC DEVICE MANUFACTURING SYSTEM MONITORING AND CONTROL";
U.S. Patent Application Serial No. 10/650,310, filed August 28, 2003, and titled "SYSTEM FOR TRANSPORTING SUBSTRATE CARRIERS";
U.S. Patent Application Serial No. 10/764,982, filed January 26, 2004, and titled "METHODS AND APPARATUS FOR TRANSPORTING SUBSTRATE CARRIERS";
U.S. Patent Application Serial No. 10/650,480, filed August 28, 2003, and titled "SUBSTRATE CARRIER HANDLER THAT UNLOADS SUBSTRATE CARRIERS DIRECTLY FROM A MOVING CONVEYOR"; and
U.S. Patent Application Serial No. 10/987,955, filed November 12, 2004, and titled "BREAK-AWAY POSITIONING CONVEYOR MOUNT FOR ACCOMMODATING CONVEYOR BELT BENDS".

Embodiments of the present invention provide methods and apparatus for operating a substrate carrier handler under the control of a material control system (MCS). The features of the present invention are particularly advantageous with the use of single or small lot size substrate carriers. As used herein, the term "small lot size" substrate carrier or "small lot" carrier may refer to a carrier that is adapted to hold fewer substrates than a conventional "large lot size" carrier which typically holds thirteen or twenty-five substrates. As an example, a small lot size carrier may be adapted to hold five or less substrates. In some embodiments, other small lot size carriers may be employed (e.g., small lot size carriers that hold one, two, three, four or more than five substrates, but less than that of a large lot size carrier). In general, each small lot size carrier may hold too few substrates for human transport of carriers to be viable within an electronic device or other manufacturing facility. Enhanced carrier handlers according to the present invention are adapted to accept transfer commands for carriers before the carriers actually arrive within the domain of the carrier handler. This allows a carrier handler to avoid having to wait until a carrier arrives and then having to wait further for the MCS to issue a transfer command after informing the MCS of the arrival of the carrier. Thus, using the present invention the carrier handler is able to anticipate the arrival of a carrier and facilitate improved performance and scheduling.

The carrier handler of the present invention may also be adapted to accept termination commands that result in prior transfer commands being cancelled or aborted independent of the state of the prior commands. In other words, regardless of whether a transfer command is active or queued, a single termination command can be used to cancel a queued transfer command or abort an active transfer.

In addition, a carrier handler according to the present invention may be adapted to identify a queued command that could be executed using a carrier support that is both available for use and the soonest to arrive at the carrier handler. The identified command may be selected out-of-order from the command queue for execution. This aspect of the present invention may allow improved throughput of the transport system and carrier handler by transferring carriers more efficiently and avoiding a carrier support having to circulate around the fabrication facility unnecessarily. Likewise, to further enhance throughput, queued commands may be selected for execution based upon the actual or estimated times it will take to perform the selected commands. A database may be employed to store the time required to execute each of the different transfers and/or commands the carrier handler may perform. In some embodiments, a scheduler for the carrier handler may not commit to executing a transfer command to/from the transport system until the last possible moment before the carrier handler must begin to prepare for such a transfer based on the estimated/actual times in the database.

Further, the carrier handlers of the present invention may also be adapted to remove empty carriers from associated tools to improve port availability. Thus, the present invention may remove substrates from a tool in a carrier different than in which the substrates arrived at the tool. Because the present invention facilitates ports being made available for newly arriving carriers holding unprocessed substrates, tool "starvation" may be avoided.

In some embodiments, the present invention enables the carrier handler to continue to operate even after a failed transfer. Internal storage locations of an inventive carrier handler may be tracked in a database or through the use of another mechanism. Upon determining that a transfer to (or from) an internal storage location has failed, the internal storage location associated with the failed transfer may be marked as unavailable and removed from a usable locations list.

In alternative or additional embodiments of the present invention, a carrier handler may include sensors to verify that a transfer destination is available and unobstructed before making an actual transfer. In other words, the status of a transfer destination may be sensed using, for example, an electric eye mounted on an end effector of the carrier handler. The actual status may be compared against stored status to detect any anomalies and avoid any collisions. Likewise, a pressure sensor/weight transducer for example, may be used to determine that a carrier is properly supported by the carrier handler and/or contains the expected number of substrates.

Carrier handlers according to the present invention may also be adapted to self-calibrate carrier handoffs to/from the transport system. Using a "calibration carrier" equipped with sensors and/or a communications facility, a carrier handler may be provided with sufficient information to calibrate for a handoff as, for example, the calibration carrier is moved past the carrier handler on the transport system. For example, a calibration carrier may emit a signal indicating that the calibration carrier detected that the carrier handler's end effector failed to match speed with the calibration carrier in a last pass and that the end effector may need to be moved faster.

Further, a carrier handler may be provided that may be adapted to (1) accept transfer commands for carriers before the carriers arrive within the domain of the carrier handler (302); (2) accept termination commands that result in prior commands being cancelled or aborted independent of the state of the prior commands; (3) select queued commands for out-of-order execution to take advantage of earliest arriving transport system (316) carrier supports suitable for use with the selected commands and/or based upon the anticipated time needed to execute the commands; (4) remove empty carriers from an associated tool to improve port availability; (5) continue to operate even after transfers involving storage locations fail by removing the failed locations from a usable locations list; (6) verify the integrity of carrier and transfer destination status data with sensors prior to attempting a transfer; and (7) calibrate carrier handoffs with a transport system using a calibration carrier equipped with sensors.

An electronic device manufacturing or fabrication facility (Fab) may use an overhead transport system (OHT system) that includes a plurality of carrier supports or "cradles" coupled to a continuously moving conveyor system adapted to transfer one or more substrate carriers about the facility. More specifically, the moving conveyor system may include a band and a plurality of drive motors coupled thereto, which are adapted to move the band.

Further, such a facility may include tools or composite tools adapted to process a substrate during electronic device manufacturing. Each processing tool may be coupled to a respective carrier handler adapted to transfer a substrate carrier between the tool and the moving conveyor system. More specifically, each processing tool may be coupled to a respective carrier handler adapted to transfer a substrate carrier between a load port of the processing tool and a carrier support coupled to the band of the continuously moving conveyor system. In this manner, a substrate carrier may be transferred about the facility.

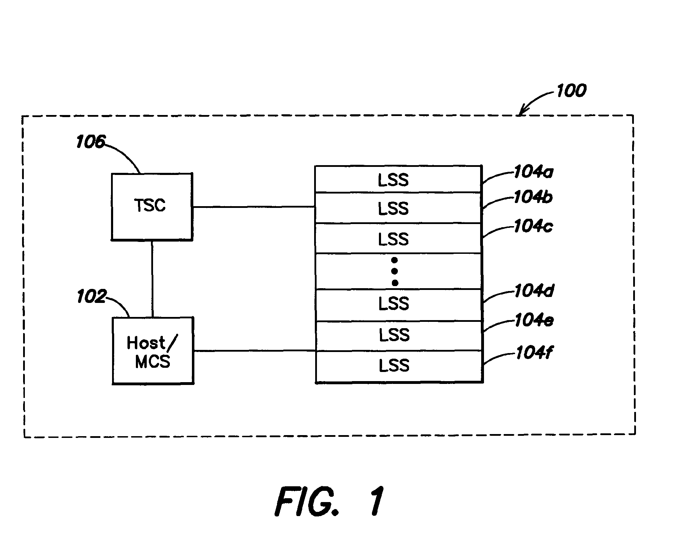

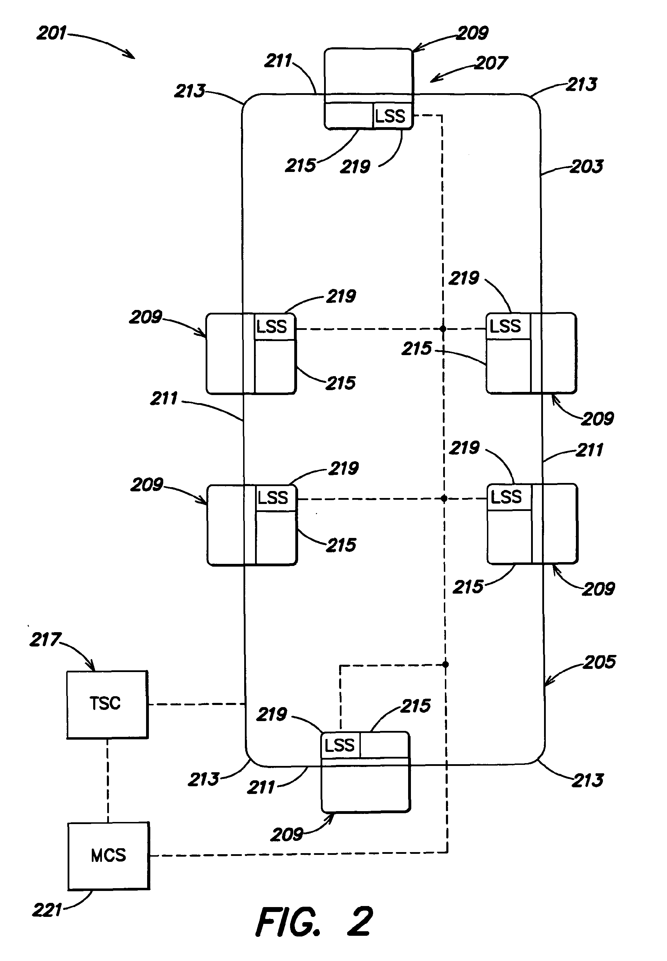

In addition, a transport system may include a control system adapted to communicate with and control operation of the moving conveyor system and a plurality of carrier handlers such that substrate carriers may be moved to where they are needed. Turning to Fig. 1, a control system 100 may include a host or MCS 102 that is in two-way communication with loading station software (LSS) 104a-f executing on each of the controllers of each of the plurality of carrier handlers housed in and/or under the control of substrate loading stations. The host may include a manufacturing execution system (MES) that directs the operations of the MCS. The MCS 102 may also be in two-way communication with a transport system controller (TSC) 106 that maintains the operation of the transport system including drive motors and the conveyor. In some embodiments, each of the LSS 104a-f nodes may communicate with the TSC 106 to directly exchange information regarding the status of the transport system. These components and their operation are described in more detail below with respect to Fig. 2.

Turning to Fig. 2, a schematic diagram is provided depicting an example embodiment of a physical arrangement of an example Fab 201 that is especially well suited for using small lot size substrate carriers, such as substrate carriers that hold a single substrate or substantially fewer than twenty-five substrates (e.g., five or less). The depicted Fab 201 includes a high-speed transport system with several features that make it particularly suitable for using small lot carriers including: a high-speed, low maintenance, constantly moving conveyor system; a carrier loading/unloading function that does not require stopping or slowing the conveyor; a conveyor that is able to physically support many carriers at one time; a flexible conveyor that may be readily customized to a desired transport path; and control software adapted to efficiently manage transport and transfers between process tools. These features are described further below.

Previously incorporated U.S. Patent Application Serial No. 10/650,310, filed August 28, 2003 and titled "System For Transporting Substrate Carriers", discloses a substrate carrier transport system or similar delivery system that includes a conveyor for substrate carriers that is intended to be constantly in motion during operation of the Fab which it serves. The constantly moving conveyor is intended to facilitate transportation of substrates within the Fab so as to reduce the total "dwell" time of each substrate in the Fab.

To operate a Fab in this manner, methods and apparatus may be provided for unloading substrate carriers from the conveyor, and for loading substrate carriers onto the conveyor, while the conveyor is in motion. Previously incorporated U.S. Patent Application Serial No. 10/650,480, filed August 28, 2003 and titled "Substrate Carrier Handler That Unloads Substrate Carriers Directly From a Moving Conveyor", discloses a substrate carrier handler at a substrate loading station or "loading station" that may perform such loading/unloading operations with respect to a moving conveyor.

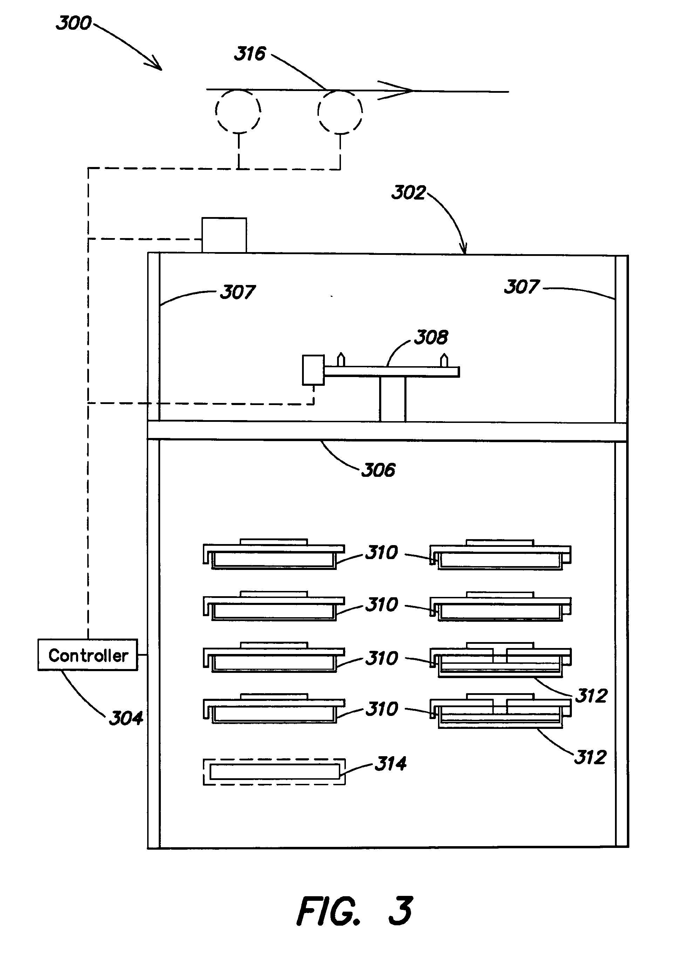

Turning to Fig. 3, a substrate loading station 300 equipped with a carrier handler 302 may include a controller 304, a horizontal guide 306 that is moveable vertically along a frame 307 or rails, and an end effector 308 that is moveable horizontally along the horizontal guide 306. Other configurations (e.g., a robot that can move in more than two dimensions) for moving the end effector 308 to execute transfers may be employed. A carrier handler 302/ substrate loading station 300 may further include internal storage locations 310 or shelves/hangers for temporarily storing substrate carriers 312. In addition, ports 314 for loading substrates into process tools (not shown) may be accessible to the carrier handler 302 or be part of a substrate loading station 300 housing a carrier handler 302.

The controller 304 may be implemented using a field programmable gate array (FPGA) or other similar device. In some embodiments, discrete components may be used to implement the controller 304. The controller 304 may be adapted to control and/or monitor the operation of the substrate loading station 300 and one or more of various electrical and mechanical components and systems of the substrate loading station 300 which are described herein. The controller 304 may be adapted to execute loading station software as indicated above. In some embodiments, the controller 304 may be any suitable computer or computer system, or may include any number of computers or computer systems.

In some embodiments, the controller 304 may be or may include any components or devices which are typically used by, or used in connection with, a computer or computer system. Although not explicitly pictured in Fig. 3, the controller 304 may include one or more central processing units, read only memory (ROM) devices and/or a random access memory (RAM) devices. The controller 304 may also include input devices such as a keyboard and/or a mouse or other pointing device, and output devices such as a printer or other device via which data and/or information may be obtained, and/or a display device such as a monitor for displaying information to a user or operator. The controller 304 may also include a transmitter and/or a receiver such as a LAN adapter or communications port for facilitating communication with other system components and/or in a network environment, one or more databases for storing any appropriate data and/or information, one or more programs or sets of instructions for executing methods of the present invention, and/or any other computer components or systems, including any peripheral devices.

According to some embodiments of the present invention, instructions of a program (e.g., controller software) may be read into a memory of the controller 304 from another medium, such as from a ROM device to a RAM device or from a LAN adapter to a RAM device. Execution of sequences of the instructions in the program may cause the controller 304 to perform one or more of the process steps described herein. In alternative embodiments, hard-wired circuitry or integrated circuits may be used in place of, or in combination with, software instructions for implementation of the processes of the present invention. Thus, embodiments of the present invention are not limited to any specific combination of hardware, firmware, and/or software. The memory may store the software for the controller which may be adapted to execute the software program, and thereby operate in accordance with the present invention, and particularly in accordance with the methods described in detail below. Portions of the present invention may be embodied as a program developed using an object oriented language that allows the modeling of complex systems with modular objects to create abstractions that are representative of real world, physical objects and their interrelationships. However, it would be understood by one of ordinary skill in the art that the invention as described herein can be implemented in many different ways using a wide range of programming techniques as well as general purpose hardware sub-systems or dedicated controllers.

The program may be stored in a compressed, uncompiled and/or encrypted format. The program furthermore may include program elements that may be generally useful, such as an operating system, a database management system and device drivers for allowing the controller to interface with computer peripheral devices and other equipment/components. Appropriate general purpose program elements are known to those skilled in the art, and need not be described in detail herein.

As indicated above, the controller 304 may generate, receive, and/or store databases including data related to carrier locations, command queues, actual and/or estimated command execution times, and/or internal storage locations. As will be understood by those skilled in the art, the schematic illustrations and accompanying descriptions of the structures and relationships presented herein are merely exemplary arrangements. Any number of other arrangements may be employed besides those suggested by the illustrations provided.

In operation, to unload a substrate carrier 312 from a transport system 316 that includes a moving conveyor that transfers substrate carriers 312 (also referred to as a "substrate carrier conveyor" 316) and that passes by the carrier handler 302, the end effector 308 is moved horizontally at a velocity that substantially matches the velocity of the substrate carrier 312 as it is being transported by the substrate carrier conveyor 316 (e.g., by substantially matching substrate carrier speed in a horizontal direction). In addition, the end effector 308 may be maintained in a position adjacent the substrate carrier 312 as the substrate carrier 312 is being transported. The end effector 308 thus may substantially match a position of the substrate carrier 312 while substantially matching a velocity of the substrate carrier 312. Likewise, conveyor position and/or velocity may be substantially matched.

While the end effector 308 substantially matches the substrate carrier's velocity (and/or position), the end effector 308 is raised so that the end effector 308 contacts the substrate carrier 312 and disengages the substrate carrier 312 from the substrate carrier conveyor 316. A substrate carrier 312 similarly may be loaded onto the moving substrate carrier conveyor 316 by substantially matching end effector 308 and conveyor velocities (and/or positions) during loading. In at least one embodiment, such substrate carrier handoffs between the end effector 308 and substrate carrier conveyor 316 are performed at a substantially zero velocity and/or acceleration difference between the end effector 308 and the substrate carrier conveyor 316.

Previously incorporated U.S. Patent Application Serial No. 10/764,982, filed January 26, 2004 and titled "Methods and Apparatus for Transporting Substrate Carriers", describes a conveyor system that may be employed with the above-described substrate carrier transport system 316 and/or carrier handler 302 for transporting substrate carriers between one or more processing tools of a electronic device manufacturing facility. The conveyor system may include a ribbon (or "band") that forms a closed loop within at least a portion of the electronic device manufacturing facility and that transports substrate carriers therein. In one or more embodiments, the ribbon or band may be formed from stainless steel, polycarbonate, composite materials (e.g., carbon graphite, fiberglass, etc.), steel or otherwise reinforced polyurethane, epoxy laminates, plastic or polymer materials that include stainless steel, fabric (e.g., carbon fiber, fiberglass, Kevlar® available from Dupont, polyethylene, steel mesh, etc.) or another stiffening material, etc. By orienting the ribbon so that a thick portion of the ribbon resides within a vertical plane and a thin portion of the ribbon resides within a horizontal plane, the ribbon is flexible in the horizontal plane and rigid in the vertical plane. Such a configuration allows the conveyor to be constructed and implemented inexpensively. For example, the ribbon requires little material to construct, is easy to fabricate and, due to its vertical rigidity/strength, can support the weight of numerous substrate carriers without supplemental support structure (such as rollers or other similar mechanisms used in conventional, horizontally-oriented belt-type conveyor systems). Furthermore, the conveyor system is highly customizable because the ribbon may be bent, bowed or otherwise shaped into numerous configurations due to its lateral flexibility.

Turning back to Fig. 2, the example Fab 201 includes a ribbon or band 203 that forms a simple loop 205 within the Fab 201. The ribbon 203 may comprise, for example, one of the ribbons described in previously incorporated U.S. Patent Application Serial No. 10/764,982. The ribbon 203 transports substrate carriers (not shown) between processing tools 209, and comprises straight portions 211 and curved portions 213 to form the (closed) loop 205. Other number of processing tools 209 and/or loop configurations may be employed.

Each processing tool 209 may include a substrate carrier handler at a substrate loading station or "loading station" 215 of the processing tool 209 for unloading a substrate carrier from or for loading a substrate carrier onto the moving ribbon 203 of the conveyor system 207 as the ribbon 203 passes by the loading station 215 (as described in previously incorporated U.S. Patent Application Serial No. 10/650,480). For example, an end effector 308 (Fig. 3) of a loading station 215 may be moved horizontally at a velocity that substantially matches the velocity of the substrate carrier as it is being transported by the ribbon 203, maintained in a position adjacent the substrate carrier as the substrate carrier is being transported and raised so that the end effector contacts the substrate carrier and disengages the substrate carrier from the conveyor system 207. A substrate carrier similarly may be loaded onto the moving ribbon 203 by substantially matching end effector 308 (Fig. 3) and ribbon velocities (and/or positions) during loading.

Each loading station 215 may include one or more ports (e.g., load ports) or similar locations where substrates or substrate carriers are placed for transfer to and/or from a processing tool 209 (e.g., one or more docking stations, although transfer locations that do not employ docking/undocking movement may be employed). Various substrate carrier storage locations or shelves also may be provided at each loading station 215 for substrate carrier buffering at a processing tool 209.

The conveyor system 207 may include a TSC 217 for controlling operation of the ribbon 203. For example the TSC 217 may control/monitor the speed and/or status of the ribbon 203, allocate carrier supports of the ribbon 203 that are used to support/transport substrate carriers, monitor the status of such carrier supports, provide such information to each loading station 215 or the like. Likewise, each loading station 215 may include loading station software (LSS) 219 for controlling carrier handler operation (e.g., loading or unloading of substrate carriers to/from the conveyor system 207, transporting of substrate carriers to/from load ports or storage locations of the loading station 215 and/or processing tool 209 serviced by the loading station 215, etc.). A MCS 221 communicates with the transport system controller 217 and the loading station software 219 of each loading station 215 for affecting operation of the same. The TSC 217, each LSS 219 and/or the MCS 221 may include a scheduler (not shown) for controlling scheduling of the operations performed by the TSC 217, LSS 219 and/or the MCS 221.

### PROCESS DESCRIPTIONS:

The system discussed above, including the hardware and software components, are useful to perform the methods of the invention. However, it should be understood that not all of the above described components are necessary to perform any of the present invention's methods. In fact, in some embodiments, none of the above described system is required to practice the present invention's methods. The system described above is an example of a system that would be useful in practicing the invention's methods and is especially well suited for transferring small lot size substrate carriers, such as substrate carriers that hold a single substrate or substantially fewer than twenty-five substrates (e.g., five or less).

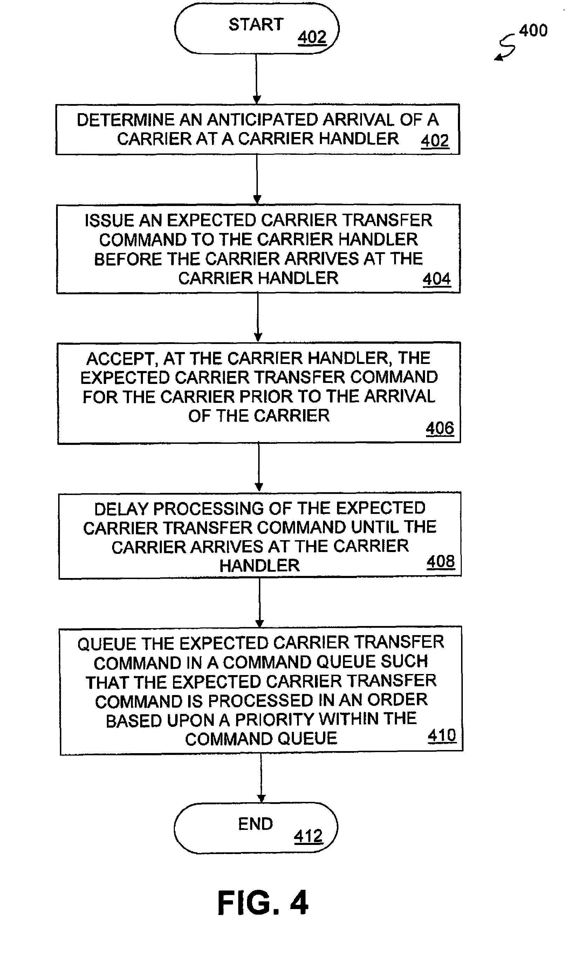

Referring to Figs. 4 through 11, flowcharts are depicted that represent some embodiments of the present invention that may be performed using the systems described above. It must be understood that the particular arrangement of elements in the flowcharts of Figs. 4 through 11, as well as the number and order of example steps of various methods discussed herein, is not meant to imply a fixed order, sequence, quantity, and/or timing to the steps; embodiments of the present invention can be practiced in any order, sequence, and/or timing that is practicable.

In the subsections that follow, method steps will be discussed in detail. Note that not all of these steps are required to perform the methods of the present invention and that additional and/or alternative steps are also discussed below. Also note that the general steps depicted in the flowcharts represent features of only some of the embodiments of the present invention and that they may be re-ordered, combined and/or subdivided in any number of different ways so that methods of the present invention include more or fewer actual steps. For example, in some embodiments many additional steps may be added to update and maintain databases described below, but as indicated, it is not necessary to use such databases in all embodiments of the invention. In other words, the methods of the present invention may contain any number of steps that are practicable to implement the several different inventive processes described herein.

As indicated above, the MCS 221 is responsible for delivery and storage of carriers in a bay, by sending commands to various equipment, which include substrate loading stations/carrier handlers and transfer stations (equipment that may perform conveyor band to band transfers, not shown herein). In some embodiments, certain aspects of the carrier handler may me implemented in conformance with an industry standard entitled the SEMI E88-1103 standard "Specification for AMHS Storage SEM (Stocker SEM)", which in particular details standardized commands and protocols for control of compliant devices. Likewise, a TSC 117, which is responsible for controlling conveyor operation, may be implemented in conformance with the SEMI E82-0703 standard "Specification for Interbay/Intrabay AMHS SEM (IBSEM)". Interactions with a tool's port may me implemented in conformance with the SEMI E84-0703 standard "Specification for Enhanced Carrier Handoff Parallel I/O Interface" and handling of carriers may be implemented in conformance with the SEMI E87-0703 standard "Specification for Carrier Management (CMS)". These four standards are published by the Semiconductor Equipment and Materials International (SEMI) industry coalition group of San Jose, CA (www.semi.org) and are hereby incorporated herein by reference for all purposes.

Embodiments of the present invention implement features beyond the functions described in the above referenced SEMI standards. More specifically, the present invention adds enhanced functions to the SEMI E88 standard to further improve the efficiency and throughput of a Fab that uses small lot size carriers. A general goal in single or small lot size substrate processing is to reduce delays resulting from the time between a carrier arriving at the port of a SEMI E88 compliant stocker-type device, such as a substrate loading station with a carrier handler, and the MCS acknowledging the arrival and sending a command to move the carrier to a final destination. For carriers designed to hold a single substrate, since the number of carriers arriving at a carrier handler may be twenty-five times more than that of a conventional delivery system, the cumulative delay may become significant. The SEMI E88 specification requires that the HOST/MCS send a transfer command to a carrier handler (e.g., stocker equipment) only after the arrival of the carrier at a load port of the associated substrate loading station (e.g., a shelf or similar intermediate storage location of the substrate loading station from which the carrier then may be transferred to a port of a processing tool serviced by the substrate loading station). This requirement results in cumulative delays in moving carriers to the destination port. According to the SEMI E88 specification, if a transfer command is issued to a stocker and the specified carrier does not exist within the stocker's domain, the stocker would respond with an error. The error is properly generated in conformance with the SEMI E88 standard because the stocker cannot perform the command on a carrier not in the stocker's domain.

### SEMI E88 ENHANCEMENTS:

Embodiments of the present invention extend the SEMI E88 standard to allow the substrate loading station to accept a transfer command prior to the arrival of an associated carrier (e.g., without prior knowledge of the existence of the specified carrier), in anticipation of the carrier's arrival. Such an enhanced transfer command may identified as an "expected carrier" transfer by the use of an additional parameter within the command. The substrate loading station may defer the processing of such transfer commands until the specified carrier enters the domain of the substrate loading station. Upon entering the domain of the substrate loading station, an expected carrier command may be processed in order of its priority in a command queue of the carrier handler.

More specifically, according to some embodiments of an implementation of an enhanced E88 specification of the present invention, if an expected carrier transfer command is received, the substrate loading station may return a reply to the MCS that the command will be completed later. The substrate loading station may keep the command in the carrier handler's queue until the carrier arrives and when the carrier does arrive, the command may be executed as per the MCS request. In addition to avoiding introducing delays waiting for a transfer command after a carrier arrives, the present invention also allows a scheduler of the substrate loading station to plan for more efficient carrier transfers, e.g., directly from the transport system to a port of a processing tool, instead of having to put newly arriving carriers into temporary storage locations.

Turning to Fig. 4, an example process 400 for accepting a transfer command before a carrier arrives at a carrier handler is depicted. The process 400 starts at step 402. In Step 404, the MCS is aware that, or determines that, a carrier is being transported to a destination carrier handler, possibly as a result of a source carrier handler having loaded the carrier onto the transport system, for example. In step 404, before the carrier arrives at the destination carrier handler, the MCS issues a transfer command to the destination carrier handler with an "expected carrier" parameter set. In step 406, the destination carrier handler accepts and acknowledges the expected carrier transfer command even though the specified carrier handler has not yet arrived at the destination carrier handler. In step 408, processing of the expected carrier transfer command is delayed until the specified carrier appears within the domain of the destination substrate loading station (e.g., arrives at the destination carrier handler). In step 410, the expected carrier transfer command is queued in the command queue of the destination carrier handler were it may be processed in order based upon a priority within the queue. In step 412, the example process 400 for accepting a transfer command before a carrier arrives at a carrier handler ends.

In some alternative embodiments, in step 408, the expected carrier transfer command may be queued in the command queue of the destination carrier handler upon receipt and, in step 410, execution of the expected carrier transfer command may be scheduled to commence based upon an anticipated arrival time of the carrier.

The SEMI E82 and SEMI E88 standards define a number of commands for remote operation. In particular, two remote commands are defined for abort and cancel for use in terminating transfer commands in automated material handling systems. The abort command terminates the activity of a specific transfer command based on a command identifier while the command is in the active state. The cancel command terminates the activity of a specific transfer command based on command identifier while the command is in either the queued or waiting state.

An additional enhancement of the SEMI E88 and E82 standards according to the present invention involves consolidating related commands that were intended to apply to different command execution states. For example, the abort command intended to terminate active commands and the cancel command intended to terminate queued commands may be consolidated into a single termination command. A general goal in single or small lot size substrate processing is to reduce the number of messages between the HOST/MCS and SEMI-E88 compliant stocker-type equipment, such as a substrate loading station. As indicated above, the SEMI E88 specification requires that the HOST/MCS send a cancel command to cancel a transfer if it is in the queued state and send an abort command to abort a transfer if it is in the active state. This requirement results in cumulative unnecessary extra messaging, particularly when the state of the transfer changes right after the HOST/MCS has issues a cancel command and before the stocker processes this command.

An embodiment of the present invention extends the SEMI E88 specification to allow for a new termination command (e.g., AbortOrCancel), which results in the cancellation or aborting of a transfer depending on whether it is in the queued or active state. Thus, the new termination command terminates the activity of a specific transfer command based on a command identifier only, independent of the command state. As a result, the termination command may be used in place of either the abort or cancel commands without regard to the command state. This usage results in less code needed to implement several functions.

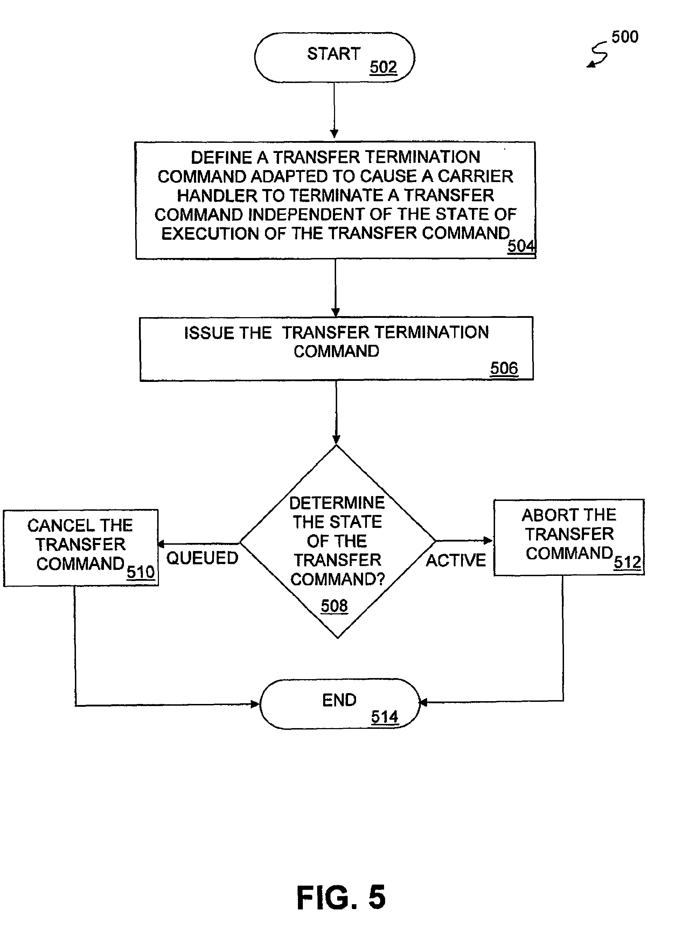

Turning to Fig. 5, an example process 500 for terminating a transfer command independent of the command's execution status is depicted. The process 500 commences at step 502. In step 504, a termination command is defined that aborts or cancels a transfer regardless of whether the transfer is active, queued, or waiting. In step 506, the termination command is issued by the MCS. In step 508, the substrate loading station controller receives the termination command and determines the state of the transfer command identified in the termination command. If the specified transfer command is queued or waiting, the transfer command is canceled in step 510. If the specified transfer command is active, the transfer command is aborted in step 512. In either case, the process 500 ends in step 514.

### LOOK-AHEAD SCHEDULING OF A SUBSTRATE LOADING STATION:

A substrate loading station's carrier handler actively places or removes carriers onto/from specific locations of a transport system (e.g., cradles or other supporting locations). Since the transport system does not stop at the substrate loading station for such transfers, the carrier handler must be in place to make such transfers prior to the arrival of the target carrier support (e.g., before a cradle supporting the carrier to be unloaded, or the cradle onto which the carrier is to be loaded, arrives). A goal of the scheduler of a substrate loading station is to insure that the placement or removal of a carrier at a carrier support on the transport system is done the first time the carrier support passes by the substrate loading station.

To improve the chances of achieving this goal, the present invention provides the scheduler of the carrier handler with a look-ahead feature in its logic for deciding which transfer command in the command queue to initiate next. This look-ahead feature may take into account the anticipated time of the earliest arriving carrier support for initiating a transfer to load a carrier onto a carrier support of a moving conveyor (e.g., place-on-cradle) or to unload a carrier from a carrier support of a moving conveyor (e.g., remove-from-cradle). For example, before performing a transfer to/from a port of a processing tool serviced by the substrate loading station, the scheduler logic of the substrate loading station may also take into account the time required to perform such a transfer and whether enough time exists to perform such a transfer and also be ready for a transfer to/from the transport system using the earliest arriving carrier support.

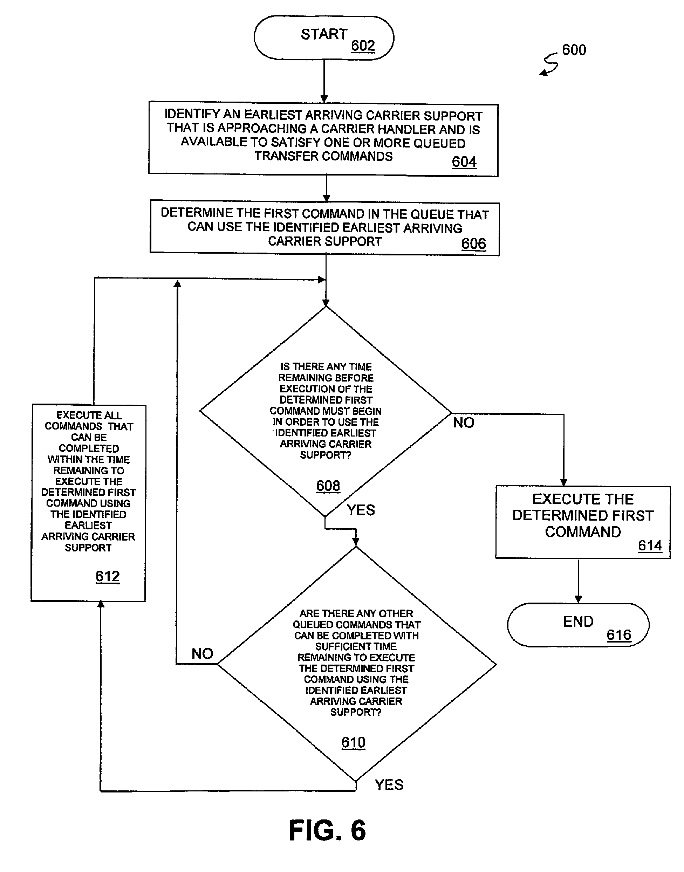

Turning to Fig. 6, an example process 600 for looking ahead into a command queue to find a command that can use the earliest arriving available carrier support is depicted. The process 600 commences at step 602. In step 604, a carrier handler/substrate loading station determines or identifies the earliest arriving carrier support that is available to satisfy a queued transfer command. If the carrier handler has a transfer command queued that specifies transferring a carrier to the transport system, the carrier handler may look for the earliest arriving empty carrier support. Likewise, if the carrier handler has a transfer command queued that specifies transferring a carrier from the transport system, the carrier handler may look for the earliest arriving carrier support holding a carrier destined for the carrier handler.

In step 606, the first command in the queue that can use the identified carrier from Step 604 is determined. In step 608, the carrier handler determines if there is any time remaining to execute other commands before execution of the first command determined in step 606 must begin in order to use the earliest arriving carrier support identified in step 604. If there is time, then, in step 610, the carrier handler determines if any other commands can be completed before the carrier support identified in step 604 as the earliest arriving carrier support actually arrives. If there are commands that can be completed in time, then in step 612, those commands are executed and the process flow returns to the determination of step 608. If there are no commands that can be completed in time, process flow loops between steps 608 and 610 waiting for either (1) a new command to be added to the command queue that can be completed before the first command determined in step 606 must be started, or (2) time runs out and the first command determined in step 606 must be started in order to meet the carrier support identified in step 604. Returning to step 608, if the carrier handler determines that there is no time remaining to execute other commands before execution of the first command determined in step 606 must begin in order to use the earliest arriving carrier support identified in step 604, the first command is executed in step 614 and the process 600 ends in step 616.

### STORING TRANSFER TIMES:

Another, more general goal of the scheduler of a substrate loading station is to maximize the number of carriers that can be delivered to a port of an associated processing tool such that the tool is not "starved" (e.g., the tool does not have to suspend processing to wait for the delivery of additional substrates). The scheduler attempts to balance the requirement to supply the tool with new substrates with requirements for maximizing the number of carriers that can be delivered to the tool by the HOST/MCS (via the transport system and the carrier handler).

To optimize throughput, the scheduler may measure/determine and track estimated and actual times for each of the different types of movements the carrier handler is capable of performing or commands the carrier handler can execute. The scheduler's logic for selecting the next queued transfer to initiate, may use, for example, transfer times between storage locations and ports of processing tools, transfer times between storage locations and the transport system, the time it takes to move into position for a handoff with the transport system, etc. In some embodiments, the scheduler may not commit the carrier handler to performing a transfer associated with a handoff to/from the transport system, until the last possible moment required to move the carrier handler in position for such a handoff, based on the estimated/actual times stored in a time tracking database. More generally, the scheduler may not commit the carrier handler to executing a command associated with an external event (e.g., a handoff with the transport system or competition of substrate processing in a processing tool), until the last possible moment before the carrier handler has to start executing the command in conjunction with the external event. In other words, execution of commands that involve or interact with equipment external to, and not under the control of, the carrier handler/substrate loading station, may be delayed so that performance of the commands properly coincide with the actions of the external equipment (e.g., the arrival of a carrier support at the substrate loading station).

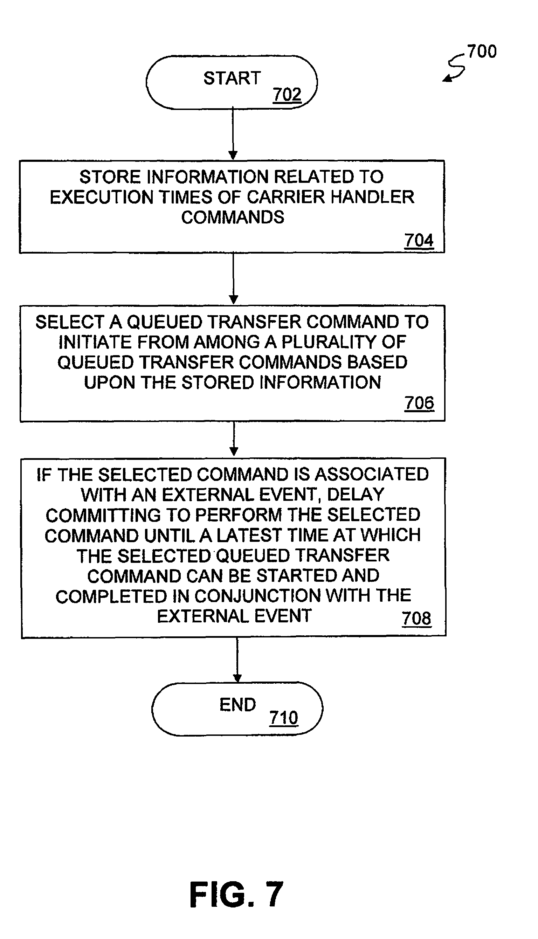

Turning to Fig. 7, an example process 700 for storing and using execution times to efficiently schedule commands is depicted. The process 700 commences at step 702. In step 704, information related to execution times of various carrier handler commands are stored. The information may be a record of actual execution time measured during prior execution of the commands. In some embodiments, the information may be an estimate of execution times based upon a calculated value or an average of actual measured times. The information may include, for example, the amount of time it takes to transfer a carrier between various storage locations and various tool ports, between various storage locations and the transport system, and the amount of time it takes to move the carrier handler into position for a handoff with the transport system (e.g., time to prepare for a handoff to, or from, the transport system). The information may be stored in a storage device (e.g., memory, hard drive, etc.) as a database, a table, or in any number of other structures or formats.

In step 706, the carrier handler selects a transfer command for execution from among the commands in a command queue based upon the information stored in step 704. For example, a lower priority command that can be completed before a next carrier support arrives at the carrier handler may be selected for execution because such lower priority command represents the best/most efficient use of the carrier handler at the time (e.g., instead of merely waiting for the carrier support to arrive to execute a high priority command).

In step 708, if the selected command is associated with an external event, the carrier handler may delay committing to actually executing the selected command until the last possible moment in which to start wherein the selected command can still be completed in conjunction with the external event (e.g., before a selected carrier support arrives or another command must be started). By delaying committing to actually executing the selected command associated with an external event until the last moment, other commands may be scheduled before the selected command and throughput may thus be improved without any risk of negatively impacting throughput. In step 710, the process 700 ends.

### SEMI E84/E87 ENHANCEMENTS:

In accordance with the SEMI E84 standard, once a carrier is delivered to a port of a processing tool, the tool does not release control of the carrier until the all the substrates have been processed and returned back to the carrier. The port indicates that the carrier is ready for removal by updating the carrier's SEMI E87 state model and the carrier's SEMI E84 signals associated with the port. The change in the SEMI E87 state model indicates to the HOST/MCS that the transport system should be dispatched to remove the carrier from the port. This protocol may not be optimal for single or small lot size substrate carrier systems, because the tool may be starved and the protocol may result in too many transactions between the host and tool and between the HOST/MCS and the substrate loading station. In a single substrate carrier system, the tool will become starved if the tool is capable of processing more substrates than the number of available ports.

The present invention allows for substrates delivered in one carrier to be returned in a different carrier. To allow for the removal of a carrier as soon as the carrier is empty, the SEMI E84 state machine is changed in the present invention so that the state machine contains enough information to allow a substrate loading station to automatically act on this information. Further, the SEMI E84 state transition signals may be modified to contain information about the state of the carrier as being empty/done. The transitions may also implicitly contain information about the SEMI E87 state model (e.g., the status of the carrier may be: "ready to load", "transfer blocked", "ready to unload empty", and "ready to unload done"). According to the present invention, the carrier handler does not require a HOST/MCS command to remove carriers from a port when the carrier is in either a "ready to unload empty" or "ready to unload done" state.

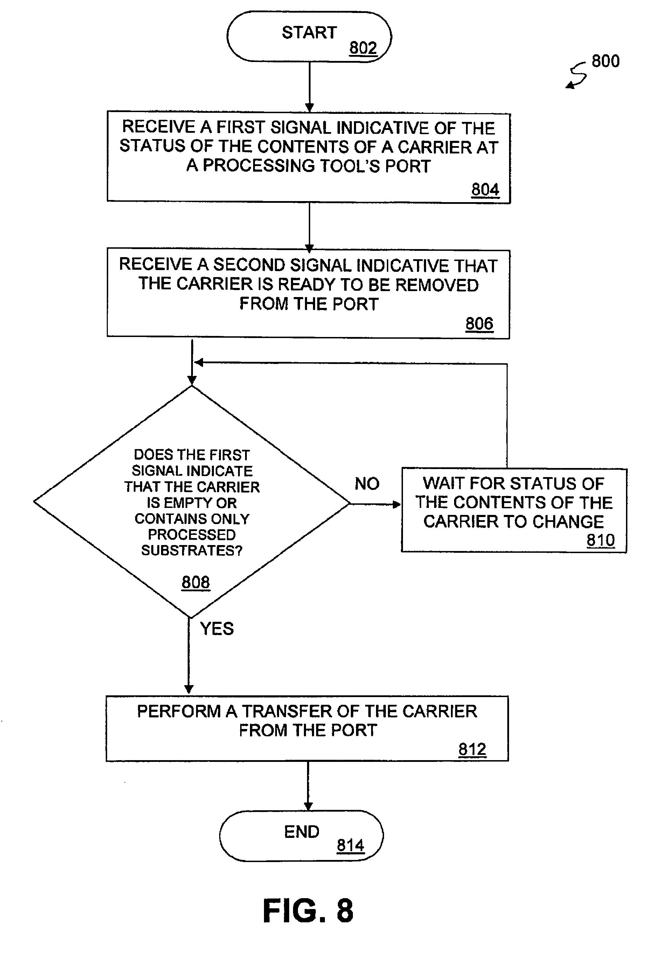

Turning to Fig. 8, an example process 800 for removal of empty substrate carriers from a processing tool is depicted. The process 800 commences at step 802. In step 804, the carrier handler receives a status signal from the port of a processing tool that the carrier handler serves. The status signal may indicate that (a) a carrier at the port contains at least one unprocessed substrate or (b) that the carrier is empty or only contains processed substrates. In step 806, a second status signal is received by the carrier handler from the port. This second signal may indicate that the carrier is ready to be removed from the port. In step 808, the carrier handler determines if the carrier may be removed because the carrier is empty or only contains processed substrates based on the first signal. If not, in step 810, the carrier handler waits for a new first signal indicating that the contents of the carrier have changed. The process flows back to step 808 from step 810 once the contents of the carrier change. If in step 808 it is determined that the carrier is empty or only contains processed substrates, the carrier handler removes the carrier from the port in step 812. The process 800 ends in step 814.

### RECOVERY FROM FAILED TRANSFERS:

According to the present invention, the scheduler and carrier handler are able to recover from most failure conditions and make the substrate loading station usable, unless the hardware of the carrier handler fails in such a way that motion is not possible or motion of the carrier handler may result in damaging carriers or substrates.

If a transfer fails because the carrier handler cannot pick or place a carrier from an internal storage location, then the location may be marked as unusable but processing of other transfer requests may continue provided that the carrier handler can be moved safely out of the location associated with the failure without damaging the carrier. If, after a failure, the carrier is still on the end effector of the carrier handler, then the carrier may be placed at an alternate storage location, so that the carrier handler may be used to execute other transfer commands.

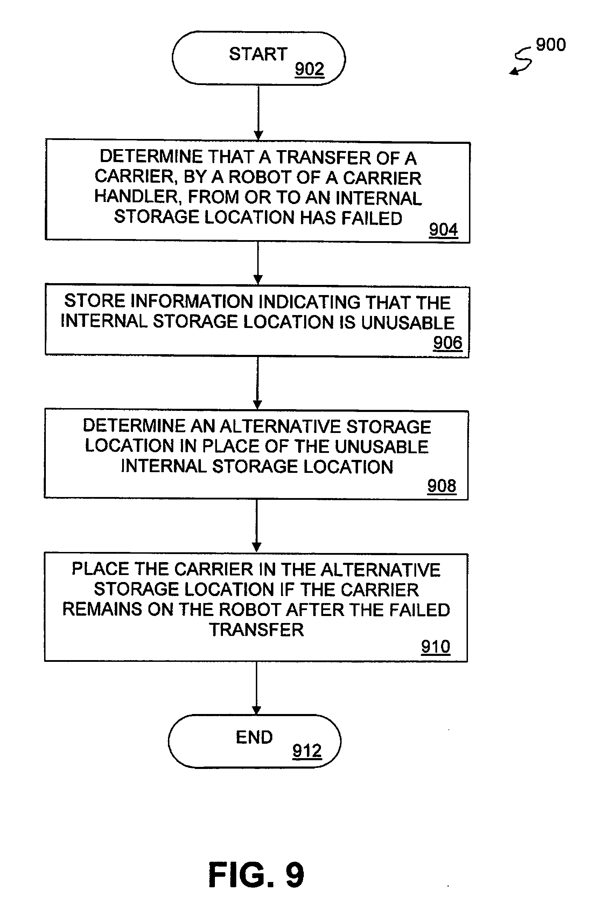

Turning to Fig. 9, an example process 900 for recovering from failed transfers is depicted. The process 900 commences at step 902. In step 904, the carrier handler determines, or becomes aware, that a carrier transfer from, or to, an internal storage location of the carrier handler's substrate loading station has failed. In some embodiments for example, a robot of a carrier handler may not be able to place a carrier because the robot's motion is obstructed by an existing carrier in the target destination location. In step 906, information indicating that that internal storage location associated with the failure in step 904 is unusable is stored in a storage device (e.g., memory, hard drive, etc.) in a database, a table, or in any number of other structures or formats. In this way, future transfers to the unusable storage location can be avoided. In step 908, an alternative storage location in the substrate loading station or in another location may be determined. In step 910, if the carrier is still on the robot of the carrier handler (e.g., it was not dropped as a result of the failure detected in step 904), then the carrier may be placed in the alternative storage location determined in step 908. The process 900 ends in step 912.

### VERIFICATION USING SENSORS:

If an internal software database error occurs within the controller of the carrier handler or, in some cases, the host/MCS, transfers may cause collision of two carriers that may result in damaging the substrates. In some embodiments, the end-effector of the robot/carrier handler may be equipped with sensors to allow verification of the validity of a handoff or transfer prior to the actual handoff so that damages to the carriers/substrates are avoided.

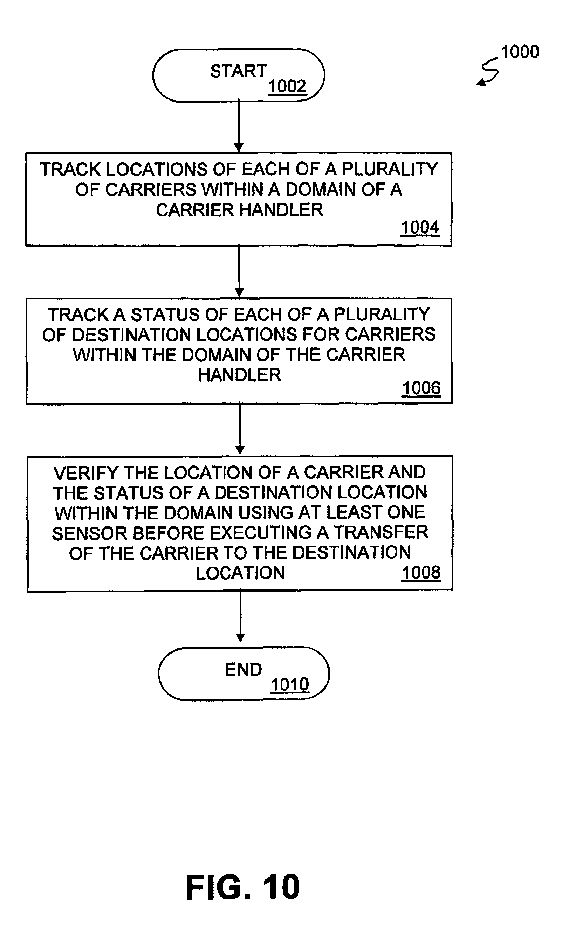

Turning to Fig. 10, an example process 1000 for verifying that stored status data is accurate before executing transfers is depicted. The process 1000 commences at step 1002. In step 1004, the locations of each carrier within the domain of a carrier handler are tracked and stored in a storage device (e.g., memory, hard drive, etc.) in a database, a table, or in any number of other structures or formats. The domain of a carrier handler may include all processing tool ports, internal and external storage locations, carrier support loading/unloading areas, end effectors, etc. under the control of the carrier handler. In step 1006, the status of each of the possible transfer destination locations (*e.g.*, processing tool ports, internal and external storage locations, carrier support loading/unloading areas, end effectors, etc.) are tracked and stored in a storage device (*e.g.*, memory, hard drive, etc.) in a database, a table, or in any number of other structures or formats. In step 1008, before a transfer to a target destination is executed, one or more physical sensors may used to verify that the correct location of the carrier to be transferred is known and that the transfer destination is available and ready to be accessed. The process 1000 ends at step 1010.

### HANDOFF CALIBRATION:

Whenever a substrate loading station with a carrier handler is installed and added to a transport system, the handoffs to/from the transport system may need to be calibrated. Calibration of such handoffs preferably is done in a way that does not disrupt the continuous operation of the transport system (*e.g.*, without stopping the conveyor). In some embodiments, carrier supports on the transport system may be reserved for special carriers that enable calibration (*e.g.*, instrumented carriers that contain sensors, cameras, other measurement devices for use during calibration, a controller, and/or communication facilities such as wireless transmitters and receivers). Calibration of handoffs to/from the transport system may be negotiated between the TSC software and the loading station software (LSS) running on the carrier handler's controller, without the HOST/MCS having any knowledge of the calibration process. The carrier support locations containing "calibration carriers" may be known to both the LSS and the TSC software.

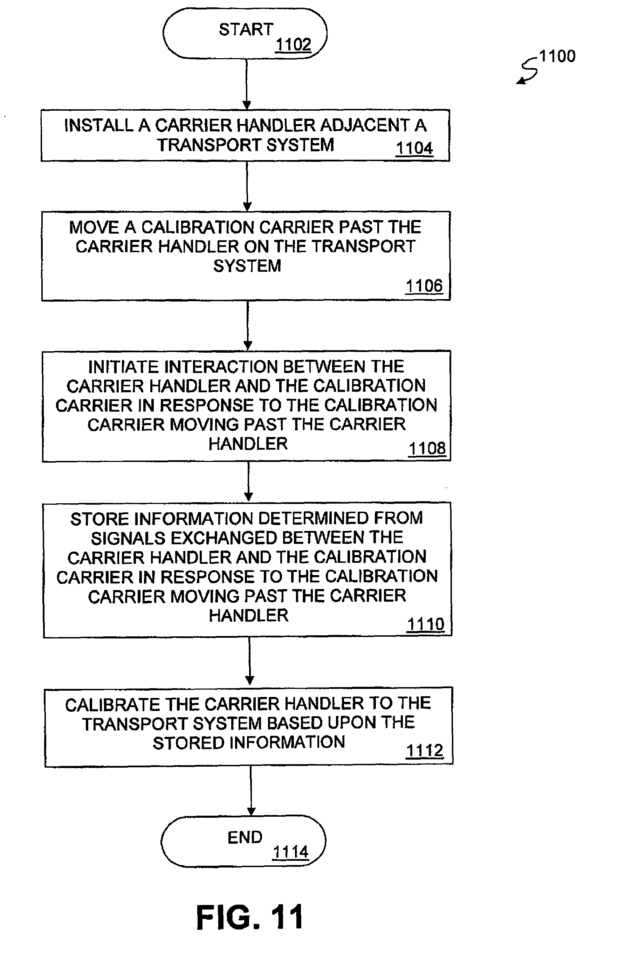

Turning to Fig. 11, an example process 1100 for calibrating a handoff between a carrier handler and a transport system without having to stop the transport system is depicted. The process 1100 commences at step 1102. In step 1104, a carrier handler/substrate loading station is installed adjacent a transport system. In step 1106, a calibration carrier is moved past the carrier handler on the transport system. In step 1108, interaction between the carrier handler and the calibration carrier is initiated in response to the calibration carrier moving past the carrier handler. In some embodiments, the calibration carrier may transmit position and velocity information wirelessly to the carrier handler equipped with a receiver. Alternatively or additionally, the carrier handler may transmit various signals to the calibration carrier indicating, for example, that the calibration carrier is approaching the carrier handler, the calibration carrier is within a loading zone of the carrier handler, etc. In step 1110, information obtained and/or determined from the calibration carrier being moved past the carrier handler is stored in a storage device (e.g., memory, hard drive, *etc.*) in a database, a table, or in any number of other structures or formats. In step 1112, the carrier handler is calibrated based upon the information stored in Step 1110. The process 1100 ends in step 1114.

The foregoing description discloses only particular embodiments of the invention; modifications of the above disclosed methods and apparatus which fall within the scope of the invention will be readily apparent to those of ordinary skill in the art. For instance, it will be understood that the invention also may be employed with any type of substrates such as a silicon substrate, a glass plate, a mask, a reticule, etc., whether patterned or unpatterned; and/or with apparatus for transporting and/or processing such substrates.

Accordingly, while the present invention has been disclosed in connection with specific embodiments thereof, it should be understood that other embodiments may fall within the spirit and scope of the invention, as defined by the following claims.

## Claims

1. A method comprising:
determining an anticipated arrival of a carrier at a carrier handler (302); and
issuing an expected carrier transfer command to the carrier handler before the carrier arrives at the carrier handler.

2. The method of claim 1 wherein the expected carrier transfer command includes a transfer command having an expected carrier argument set.

3. The method of any of claims 1 to 2 further comprising:
accepting, at the carrier handler (302), the expected carrier transfer command for the carrier prior to the arrival of the carrier at the carrier handler.

4. The method of any of claims 1 to 3 further comprising:
delaying processing of the expected carrier transfer command until the carrier arrives at the carrier handler.

5. The method of any of claims 1 to 4 further comprising:
queuing the expected carrier transfer command in a command queue such that the expected carrier transfer command is processed in an order based upon a priority within the command queue.

6. A method comprising:
providing a carrier handler adapted to remove a carrier from a transport system (316) and to load the carrier on a port of a processing tool serviced by the carrier handler (302); and
accepting a command at the carrier handler for loading the carrier on the processing tool, the command being accepted prior to arrival of the carrier at the carrier handler.

7. A method comprising:
defining a carrier handler command having an associated function of terminating a second command independent of a state in which the second command may be operating; and
issuing the carrier handler command.

8. The method of claim 7 wherein the second command includes a transfer command and the transfer command may be in a queued state or in an active state.

9. The method of claim 8 wherein issuing the carrier handler command results in canceling the transfer command if the transfer command is in a queued state and aborting the transfer command if the transfer command is in an active state.

10. A method comprising:
identifying an earliest arriving carrier support that is approaching a carrier handler (302) and is available to satisfy one or more queued transfer commands in a command queue;
selecting a queued transfer command to initiate next from among the queued transfer commands based upon an anticipated time until an arrival of the earliest arriving carrier support.

11. The method of claim 10 wherein selecting a queued transfer command to initiate next may further be based upon an anticipated time to complete execution of a preceding transfer command.

12. The method of any of claims 10 to 11 wherein selecting a queued transfer command to initiate next may further be based upon an anticipated time to prepare to execute the queued transfer command being less than the anticipated time until the arrival of the earliest arriving carrier support.

13. The method of any of claims 10 to 12 wherein carrier supports arrive on a continuously moving conveyor of a transport system (316).

14. The method of any of claims 10 to 13 wherein the queued transfer commands may include at least one of:
a load carrier from carrier support transfer command, and
an unload carrier from carrier support transfer command.

15. A method comprising:
storing information related to execution times of carrier handler commands; and
selecting a queued transfer command to initiate next from among a plurality of queued transfer commands based upon the stored information.

16. The method of claim 15 further comprising:
delaying committing to perform the selected queued transfer command until a latest time at which the selected queued transfer command can be started and completed in conjunction with an external event.

17. The method of claim 16 wherein the external event includes arrival of an earliest arriving carrier support available to satisfy the selected queued transfer command.

18. The method of any of claims 16 to 17 wherein the latest time at which the selected queued transfer command can be started and completed is determined based upon the stored information.

19. The method of any of claims 15 to 18 wherein the stored information related to execution times of carrier handler commands includes at least one of an actual time to perform an operation and an estimated time to perform an operation.

20. The method of any of claims 15 to 19 wherein the stored information related to execution times of carrier handler commands includes at least one of:
a transfer time between a storage location and a port,
a transfer time between a storage location and a transport system (316), and
a time to prepare to for a handoff with a transport system.

21. A method comprising:
receiving a first signal indicative of a status of contents of a carrier at a port associated with a tool, wherein the status indicates whether
(1) the carrier contains one or more substrates to be processed by the tool, or
(2) the carrier is empty or contains only one or more substrates that have already been processed by the tool;
receiving a second signal indicative that the carrier is ready to be removed from the port; and
performing a transfer of the carrier based upon the first and second signals.

22. The method of claim 21 wherein a substrate may be removed from the tool in a second carrier that is different than a first carrier in which the substrate arrived at the tool.

23. The method of any of claims 21 to 22 wherein performing a transfer is executed by a carrier handler (302) adapted to receive the first and second signals, and operable to remove an empty carrier to make the port available for a loaded carrier.

24. A method comprising:
determining that a transfer of a carrier, by a robot of a carrier handler (302), from or to an internal storage location has failed;
storing information indicating that the internal storage location is unusable; and
determining an alternative storage location in place of the unusable internal storage location.

25. The method of claim 24 further including placing the carrier in the alternative storage location if the carrier remains on the robot after the failed transfer.

26. A method comprising:
tracking locations of each of a plurality of carriers within a domain of a carrier handler (302);
tracking a status of each of a plurality of destination locations for carriers within the domain of the carrier handler; and
verifying the location of a carrier and the status of a destination location within the domain using at least one sensor before executing a transfer of the carrier to the destination location.

27. The method of claim 26 wherein the at least one sensor is mounted on an end-effector of a robot adapted to execute the transfer.

28. A method comprising:
installing a carrier handler adjacent a transport system (316) ;
moving a calibration carrier past the carrier handler; and
calibrating the carrier handler to the transport system based upon information determined from the calibration carrier moving past the carrier handler (302) on the transport system.

29. The method of claim 28 further including:
initiating interaction between the carrier handler and the calibration carrier in response to the calibration carrier moving past the carrier handler.

30. The method of any of claims 28 to 29 further including:
storing the information determined from signals exchanged between the carrier handler and the calibration carrier in response to the calibration carrier moving past the carrier handler.

31. The method of any of claim 28 to 30 wherein calibrating the carrier handler to the transport system (316) includes calibrating a carrier handoff with the transport system.

32. The method of any of claim 28 to 31 wherein calibrating the carrier handler (302) to the transport system includes negotiating calibration parameters between a transport system controller (106) and a carrier handler controller.

33. The method of claim 32 wherein the calibration carrier is conveyed by the transport system on a designated carrier support known to the transport system controller (106) and the carrier handler controller.

34. The method of any of claim 28 to 33 wherein the calibration carrier includes one or more sensors adapted to detect a position of a robot of the carrier handler.
